# EUROPEAN PATENT APPLICATION

(11) **EP 3 772 710 A1**
(43) Date of publication of application: **10.02.2021**
(21) Application number: 20171744.4
(22) Date of filing: 28.04.2020
(51) Int. Cl.: G06N 20/00

(54) **ARTIFICIAL INTELLIGENCE SERVER**

(30) Priority: 08.08.2019 WO PCT/KR2019/010013
(71) Applicant: LG Electronics Inc., Seoul 07336 (KR)
(72) Inventor: HAN, Jongwoo, Seoul 06772 (KR); KIM, Jaehong, Seoul 06772 (KR); KIM, Hyoeun, Seoul 06772 (KR); LEE, Taeho, Seoul 06772 (KR); JEON, Hyejeong, Seoul 06772 (KR); JEONG, Hangil, Seoul 06772 (KR); CHOI, Heeyeon, Seoul 06772 (KR)
(74) Representative: Vossius & Partner Patentanwälte Rechtsanwälte mbB

(57) **Abstract**

An artificial intelligence server is disclosed. The artificial intelligence server includes an input unit to which input data is inputted, and a processor, when a first output value outputted by an artificial intelligence model with respect to first input data is correct and a second output value outputted by the artificial intelligence model with respect to second input data is incorrect, configured to use the first input data and the second input data to obtain a first domain causing an incorrect answer, and train the artificial intelligence model to be domain-adapted for the first domain.

## Description

### TECHNICAL FIELD

The present invention relates to an artificial intelligence server that can improve the performance of an artificial intelligence model by training the artificial intelligence model to be domain adaptation (domain adaptation) to the various domains that caused the incorrect answer.

### BACKGROUND ART

Artificial intelligence is a field of computer science and information technology that studies a method for computers to do thinking, learning, and self-development that human intelligence can do and means enabling computers to imitate human intelligent behavior.

In addition, artificial intelligence does not exist by itself, but is directly or indirectly related to other fields of computer science. Especially in modern days, artificial intelligence elements are introduced in various fields of information technology so that attempts are being actively made to solve problems in the field.

Meanwhile, technologies for recognizing and learning the surrounding situation using artificial intelligence, providing information desired by a user in a desired form, or performing a desired operation or function have been actively studied.

Then, an electronic device providing such various operations and functions may be referred to as an artificial intelligence device.

Meanwhile, the AI model is trained in a lab environment and released as a product.

However, since the laboratory environment and the actual use environment of the artificial intelligence model may be different, the performance of the artificial intelligence model may be lower than that of the laboratory environment.

For example, the designer of the artificial intelligence model has trained a speech recognition model using speech data collected in a quiet environment (i.e., a low noise environment). However, when a product equipped with a speech recognition model is used in a noisy environment (high noise environment), the performance of the speech recognition model may be lowered because a loud noise data is inputted to the speech recognition model.

Therefore, the need of improving the performance by detecting the difference between the environment in which the artificial intelligence model is trained and the actual use environment and training the deep learning model according to this difference has emerged.

### DISCLOSURE OF THE INVENTION

### TECHNICAL PROBLEM

The present invention relates to an artificial intelligence server that can improve the performance of an artificial intelligence model by training the artificial intelligence model to be domain adaptation (domain adaptation) to the various domains that caused the incorrect answer.

### TECHNICAL SOLUTION

According to an embodiment of the present invention, an artificial intelligence server includes an input unit to which input data is inputted, and a processor, when a first output value outputted by an artificial intelligence model with respect to first input data is correct and a second output value outputted by the artificial intelligence model with respect to second input data is incorrect, configured to use the first input data and the second input data to obtain a first domain causing an incorrect answer, and train the artificial intelligence model to be domain-adapted for the first domain.

### ADVANTAGEOUS EFFECTS

The present invention has the advantage of constantly improving the performance of the artificial intelligence model by repeatedly performing domain adaptation.

In addition, since the present invention determines the domain causing the most incorrect answer and first performs domain adaptation on the domain causing the most incorrect answer, there is an advantage to improve the performance of the artificial intelligence model faster.

In addition, according to the present invention, since domain adaptation is repeatedly performed while changing a domain that is to be a target of domain adaptation, various domains are domain-adapted. Therefore, there is an advantage of improving the performance of the artificial intelligence model more quickly.

In addition, according to the present invention, each time the domain adaptation is repeatedly performed, the domain adaptation is performed by selecting a domain causing the most incorrect answer. Therefore, there is an advantage of improving the performance of the artificial intelligence model more quickly.

According to the present invention, the performance of the AI model can be improved by performing domain adaptation in various combinations and selecting the artificial intelligence model having the highest performance.

According to the present invention, some artificial intelligence models of the plurality of artificial intelligence models are not additionally trained or some artificial intelligence models are deleted from the memory, thereby reducing the amount of computation and storage space.

### BRIEF DESCRIPTION OF THE DRAWINGS

Fig. 1 illustrates an AI apparatus 100 according to an embodiment of the present invention.
Fig. 2 illustrates an AI server 200 according to an embodiment of the present invention.
Fig. 3 illustrates an AI system 1 according to an embodiment of the present invention.
Fig. 4 is a view illustrating an operation method of an AI server according to an embodiment of the present invention.
Figs. 5 and 7 are views for describing a method of acquiring a domain causing an incorrect answer according to an embodiment of the present invention.
Fig. 8 is a view illustrating a domain adaptation method.
Fig. 9 is a view for describing domain adaptation using Domain Adversarial Training of Neural Networks (DANN) according to an embodiment of the present invention.
Fig. 10 is a view for describing a method of selecting an artificial intelligence model having optimal performance while repeatedly performing domain adaptation and then, managing a history.
Fig. 11 is a view for describing a method of extracting an important word from a spoken text and acquiring a domain causing an incorrect answer using a feature extracted from the important word according to an embodiment of the present invention.
Fig. 12 is a view for describing a method of acquiring a low confidence word and distinguishing the low confidence word using the importance of the low confidence word according to an embodiment of the present invention.

### MODE FOR CARRYING OUT THE INVENTION

Hereinafter, embodiments of the present disclosure are described in more detail with reference to accompanying drawings and regardless of the drawings symbols, same or similar components are assigned with the same reference numerals and thus overlapping descriptions for those are omitted. The suffixes "module" and "unit" for components used in the description below are assigned or mixed in consideration of easiness in writing the specification and do not have distinctive meanings or roles by themselves. In the following description, detailed descriptions of well-known functions or constructions will be omitted since they would obscure the invention in unnecessary detail. Additionally, the accompanying drawings are used to help easily understanding embodiments disclosed herein but the technical idea of the present disclosure is not limited thereto. It should be understood that all of variations, equivalents or substitutes contained in the concept and technical scope of the present disclosure are also included.

It will be understood that the terms "first" and "second" are used herein to describe various components but these components should not be limited by these terms. These terms are used only to distinguish one component from other components.

In this disclosure below, when one part (or element, device, etc.) is referred to as being 'connected' to another part (or element, device, etc.), it should be understood that the former can be 'directly connected' to the latter, or 'electrically connected' to the latter via an intervening part (or element, device, etc.). It will be further understood that when one component is referred to as being 'directly connected' or 'directly linked' to another component, it means that no intervening component is present.

### <Artificial Intelligence (AI)>

Artificial intelligence refers to the field of studying artificial intelligence or methodology for making artificial intelligence, and machine learning refers to the field of defining various issues dealt with in the field of artificial intelligence and studying methodology for solving the various issues. Machine learning is defined as an algorithm that enhances the performance of a certain task through a steady experience with the certain task.

An artificial neural network (ANN) is a model used in machine learning and may mean a whole model of problem-solving ability which is composed of artificial neurons (nodes) that form a network by synaptic connections. The artificial neural network can be defined by a connection pattern between neurons in different layers, a learning process for updating model parameters, and an activation function for generating an output value.

The artificial neural network may include an input layer, an output layer, and optionally one or more hidden layers. Each layer includes one or more neurons, and the artificial neural network may include a synapse that links neurons to neurons. In the artificial neural network, each neuron may output the function value of the activation function for input signals, weights, and deflections input through the synapse.

Model parameters refer to parameters determined through learning and include a weight value of synaptic connection and deflection of neurons. A hyperparameter means a parameter to be set in the machine learning algorithm before learning, and includes a learning rate, a repetition number, a mini batch size, and an initialization function.

The purpose of the learning of the artificial neural network may be to determine the model parameters that minimize a loss function. The loss function may be used as an index to determine optimal model parameters in the learning process of the artificial neural network.

Machine learning may be classified into supervised learning, unsupervised learning, and reinforcement learning according to a learning method.

The supervised learning may refer to a method of learning an artificial neural network in a state in which a label for learning data is given, and the label may mean the correct answer (or result value) that the artificial neural network must infer when the learning data is input to the artificial neural network. The unsupervised learning may refer to a method of learning an artificial neural network in a state in which a label for learning data is not given. The reinforcement learning may refer to a learning method in which an agent defined in a certain environment learns to select a behavior or a behavior sequence that maximizes cumulative compensation in each state.

Machine learning, which is implemented as a deep neural network (DNN) including a plurality of hidden layers among artificial neural networks, is also referred to as deep learning, and the deep running is part of machine running. In the following, machine learning is used to mean deep running.

### <Robot>

A robot may refer to a machine that automatically processes or operates a given task by its own ability. In particular, a robot having a function of recognizing an environment and performing a self-determination operation may be referred to as an intelligent robot.

Robots may be classified into industrial robots, medical robots, home robots, military robots, and the like according to the use purpose or field.

The robot includes a driving unit may include an actuator or a motor and may perform various physical operations such as moving a robot joint. In addition, a movable robot may include a wheel, a brake, a propeller, and the like in a driving unit, and may travel on the ground through the driving unit or fly in the air.

### <Self-Driving>

Self-driving refers to a technique of driving for oneself, and a self-driving vehicle refers to a vehicle that travels without an operation of a user or with a minimum operation of a user.

For example, the self-driving may include a technology for maintaining a lane while driving, a technology for automatically adjusting a speed, such as adaptive cruise control, a technique for automatically traveling along a predetermined route, and a technology for automatically setting and traveling a route when a destination is set.

The vehicle may include a vehicle having only an internal combustion engine, a hybrid vehicle having an internal combustion engine and an electric motor together, and an electric vehicle having only an electric motor, and may include not only an automobile but also a train, a motorcycle, and the like.

At this time, the self-driving vehicle may be regarded as a robot having a self-driving function.

### <eXtended Reality (XR)>

Extended reality is collectively referred to as virtual reality (VR), augmented reality (AR), and mixed reality (MR). The VR technology provides a real-world object and background only as a CG image, the AR technology provides a virtual CG image on a real object image, and the MR technology is a computer graphic technology that mixes and combines virtual objects into the real world.

The MR technology is similar to the AR technology in that the real object and the virtual object are shown together. However, in the AR technology, the virtual object is used in the form that complements the real object, whereas in the MR technology, the virtual object and the real object are used in an equal manner.

The XR technology may be applied to a head-mount display (HMD), a head-up display (HUD), a mobile phone, a tablet PC, a laptop, a desktop, a TV, a digital signage, and the like. A device to which the XR technology is applied may be referred to as an XR device.

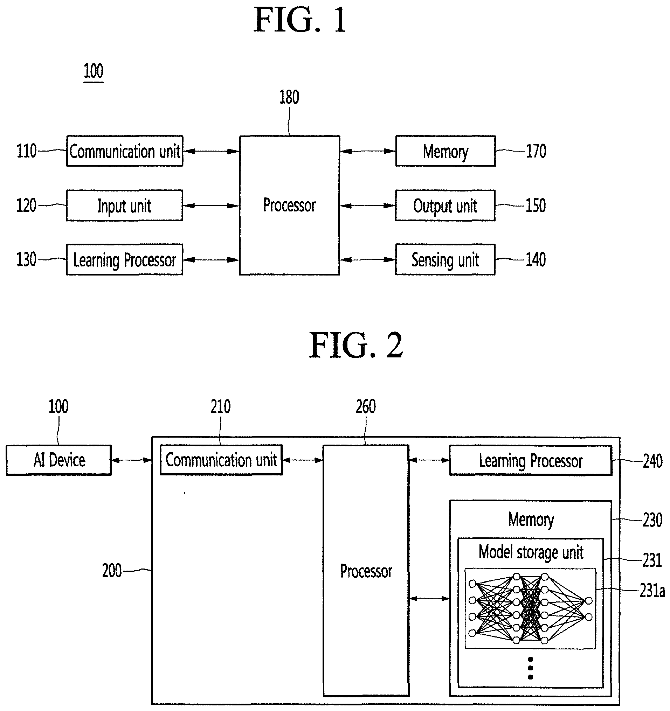

Fig. 1 illustrates an AI device 100 according to an embodiment of the present invention.

The AI device 100 may be implemented by a stationary device or a mobile device, such as a TV, a projector, a mobile phone, a smartphone, a desktop computer, a notebook, a digital broadcasting terminal, a personal digital assistant (PDA), a portable multimedia player (PMP), a navigation device, a tablet PC, a wearable device, a set-top box (STB), a DMB receiver, a radio, a washing machine, a refrigerator, a desktop computer, a digital signage, a robot, a vehicle, and the like.

Referring to Fig. 1, the AI device 100 may include a communication unit 110, an input unit 120, a learning processor 130, a sensing unit 140, an output unit 150, a memory 170, and a processor 180.

The communication unit 110 may transmit and receive data to and from external devices such as other AI devices 100a to 100e and the AI server 200 by using wire/wireless communication technology. For example, the communication unit 110 may transmit and receive sensor information, a user input, a learning model, and a control signal to and from external devices.

The communication technology used by the communication unit 110 includes GSM (Global System for Mobile communication), CDMA (Code Division Multi Access), LTE (Long Term Evolution), 5G, WLAN (Wireless LAN), Wi-Fi (Wireless-Fidelity), Bluetooth™, RFID (Radio Frequency Identification), Infrared Data Association (IrDA), ZigBee, NFC (Near Field Communication), and the like.

The input unit 120 may acquire various kinds of data.

At this time, the input unit 120 may include a camera for inputting a video signal, a microphone for receiving an audio signal, and a user input unit for receiving information from a user. The camera or the microphone may be treated as a sensor, and the signal acquired from the camera or the microphone may be referred to as sensing data or sensor information.

The input unit 120 may acquire a learning data for model learning and an input data to be used when an output is acquired by using learning model. The input unit 120 may acquire raw input data. In this case, the processor 180 or the learning processor 130 may extract an input feature by preprocessing the input data.

The learning processor 130 may learn a model composed of an artificial neural network by using learning data. The learned artificial neural network may be referred to as a learning model. The learning model may be used to an infer result value for new input data rather than learning data, and the inferred value may be used as a basis for determination to perform a certain operation.

At this time, the learning processor 130 may perform AI processing together with the learning processor 240 of the AI server 200.

At this time, the learning processor 130 may include a memory integrated or implemented in the AI device 100. Alternatively, the learning processor 130 may be implemented by using the memory 170, an external memory directly connected to the AI device 100, or a memory held in an external device.

The sensing unit 140 may acquire at least one of internal information about the AI device 100, ambient environment information about the AI device 100, and user information by using various sensors.

Examples of the sensors included in the sensing unit 140 may include a proximity sensor, an illuminance sensor, an acceleration sensor, a magnetic sensor, a gyro sensor, an inertial sensor, an RGB sensor, an IR sensor, a fingerprint recognition sensor, an ultrasonic sensor, an optical sensor, a microphone, a lidar, and a radar.

The output unit 150 may generate an output related to a visual sense, an auditory sense, or a haptic sense.

At this time, the output unit 150 may include a display unit for outputting time information, a speaker for outputting auditory information, and a haptic module for outputting haptic information.

The memory 170 may store data that supports various functions of the AI device 100. For example, the memory 170 may store input data acquired by the input unit 120, learning data, a learning model, a learning history, and the like.

The processor 180 may determine at least one executable operation of the AI device 100 based on information determined or generated by using a data analysis algorithm or a machine learning algorithm. The processor 180 may control the components of the AI device 100 to execute the determined operation.

To this end, the processor 180 may request, search, receive, or utilize data of the learning processor 130 or the memory 170. The processor 180 may control the components of the AI device 100 to execute the predicted operation or the operation determined to be desirable among the at least one executable operation.

When the connection of an external device is required to perform the determined operation, the processor 180 may generate a control signal for controlling the external device and may transmit the generated control signal to the external device.

The processor 180 may acquire intention information for the user input and may determine the user's requirements based on the acquired intention information.

The processor 180 may acquire the intention information corresponding to the user input by using at least one of a speech to text (STT) engine for converting speech input into a text string or a natural language processing (NLP) engine for acquiring intention information of a natural language.

At least one of the STT engine or the NLP engine may be configured as an artificial neural network, at least part of which is learned according to the machine learning algorithm. At least one of the STT engine or the NLP engine may be learned by the learning processor 130, may be learned by the learning processor 240 of the AI server 200, or may be learned by their distributed processing.

The processor 180 may collect history information including the operation contents of the AI apparatus 100 or the user's feedback on the operation and may store the collected history information in the memory 170 or the learning processor 130 or transmit the collected history information to the external device such as the AI server 200. The collected history information may be used to update the learning model.

The processor 180 may control at least part of the components of AI device 100 so as to drive an application program stored in memory 170. Furthermore, the processor 180 may operate two or more of the components included in the AI device 100 in combination so as to drive the application program.

Fig. 2 illustrates an AI server 200 according to an embodiment of the present invention.

Referring to Fig. 2, the AI server 200 may refer to a device that learns an artificial neural network by using a machine learning algorithm or uses a learned artificial neural network. The AI server 200 may include a plurality of servers to perform distributed processing, or may be defined as a 5G network. At this time, the AI server 200 may be included as a partial configuration of the AI device 100, and may perform at least part of the AI processing together.

The AI server 200 may include a communication unit 210, a memory 230, a learning processor 240, a processor 260, and the like.

The communication unit 210 can transmit and receive data to and from an external device such as the AI device 100.

The memory 230 may include a model storage unit 231. The model storage unit 231 may store a learning or learned model (or an artificial neural network 231a) through the learning processor 240.

The learning processor 240 may learn the artificial neural network 231a by using the learning data. The learning model may be used in a state of being mounted on the AI server 200 of the artificial neural network, or may be used in a state of being mounted on an external device such as the AI device 100.

The learning model may be implemented in hardware, software, or a combination of hardware and software. If all or part of the learning models are implemented in software, one or more instructions that constitute the learning model may be stored in memory 230.

The processor 260 may infer the result value for new input data by using the learning model and may generate a response or a control command based on the inferred result value.

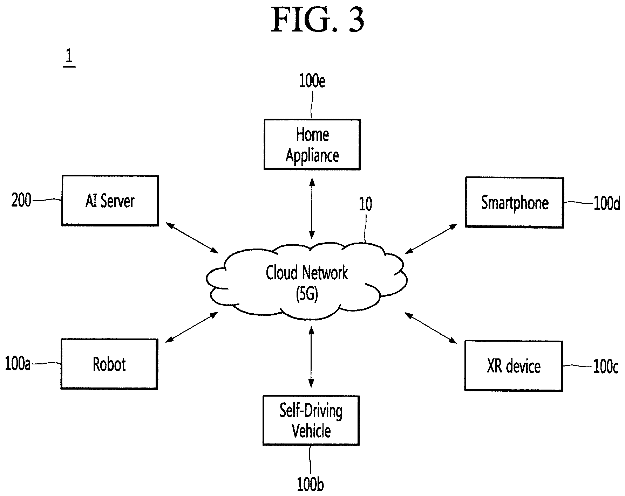

Fig. 3 illustrates an AI system 1 according to an embodiment of the present invention.

Referring to Fig. 3, in the AI system 1, at least one of an AI server 200, a robot 100a, a self-driving vehicle 100b, an XR device 100c, a smartphone 100d, or a home appliance 100e is connected to a cloud network 10. The robot 100a, the self-driving vehicle 100b, the XR device 100c, the smartphone 100d, or the home appliance 100e, to which the AI technology is applied, may be referred to as AI devices 100a to 100e.

The cloud network 10 may refer to a network that forms part of a cloud computing infrastructure or exists in a cloud computing infrastructure. The cloud network 10 may be configured by using a 3G network, a 4G or LTE network, or a 5G network.

That is, the devices 100a to 100e and 200 configuring the AI system 1 may be connected to each other through the cloud network 10. In particular, each of the devices 100a to 100e and 200 may communicate with each other through a base station, but may directly communicate with each other without using a base station.

The AI server 200 may include a server that performs AI processing and a server that performs operations on big data.

The AI server 200 may be connected to at least one of the AI devices constituting the AI system 1, that is, the robot 100a, the self-driving vehicle 100b, the XR device 100c, the smartphone 100d, or the home appliance 100e through the cloud network 10, and may assist at least part of AI processing of the connected AI devices 100a to 100e.

At this time, the AI server 200 may learn the artificial neural network according to the machine learning algorithm instead of the AI devices 100a to 100e, and may directly store the learning model or transmit the learning model to the AI devices 100a to 100e.

At this time, the AI server 200 may receive input data from the AI devices 100a to 100e, may infer the result value for the received input data by using the learning model, may generate a response or a control command based on the inferred result value, and may transmit the response or the control command to the AI devices 100a to 100e.

Alternatively, the AI devices 100a to 100e may infer the result value for the input data by directly using the learning model, and may generate the response or the control command based on the inference result.

Hereinafter, various embodiments of the AI devices 100a to 100e to which the above-described technology is applied will be described. The AI devices 100a to 100e illustrated in Fig. 3 may be regarded as a specific embodiment of the AI device 100 illustrated in Fig. 1.

### <AI + Robot>

The robot 100a, to which the AI technology is applied, may be implemented as a guide robot, a carrying robot, a cleaning robot, a wearable robot, an entertainment robot, a pet robot, an unmanned flying robot, or the like.

The robot 100a may include a robot control module for controlling the operation, and the robot control module may refer to a software module or a chip implementing the software module by hardware.

The robot 100a may acquire state information about the robot 100a by using sensor information acquired from various kinds of sensors, may detect (recognize) surrounding environment and objects, may generate map data, may determine the route and the travel plan, may determine the response to user interaction, or may determine the operation.

The robot 100a may use the sensor information acquired from at least one sensor among the lidar, the radar, and the camera so as to determine the travel route and the travel plan.

The robot 100a may perform the above-described operations by using the learning model composed of at least one artificial neural network. For example, the robot 100a may recognize the surrounding environment and the objects by using the learning model, and may determine the operation by using the recognized surrounding information or object information. The learning model may be learned directly from the robot 100a or may be learned from an external device such as the AI server 200.

At this time, the robot 100a may perform the operation by generating the result by directly using the learning model, but the sensor information may be transmitted to the external device such as the AI server 200 and the generated result may be received to perform the operation.

The robot 100a may use at least one of the map data, the object information detected from the sensor information, or the object information acquired from the external apparatus to determine the travel route and the travel plan, and may control the driving unit such that the robot 100a travels along the determined travel route and travel plan.

The map data may include object identification information about various objects arranged in the space in which the robot 100a moves. For example, the map data may include object identification information about fixed objects such as walls and doors and movable objects such as pollen and desks. The object identification information may include a name, a type, a distance, and a position.

In addition, the robot 100a may perform the operation or travel by controlling the driving unit based on the control/interaction of the user. At this time, the robot 100a may acquire the intention information of the interaction due to the user's operation or speech utterance, and may determine the response based on the acquired intention information, and may perform the operation.

### <AI + Self-Driving>

The self-driving vehicle 100b, to which the AI technology is applied, may be implemented as a mobile robot, a vehicle, an unmanned flying vehicle, or the like.

The self-driving vehicle 100b may include a self-driving control module for controlling a self-driving function, and the self-driving control module may refer to a software module or a chip implementing the software module by hardware. The self-driving control module may be included in the self-driving vehicle 100b as a component thereof, but may be implemented with separate hardware and connected to the outside of the self-driving vehicle 100b.

The self-driving vehicle 100b may acquire state information about the self-driving vehicle 100b by using sensor information acquired from various kinds of sensors, may detect (recognize) surrounding environment and objects, may generate map data, may determine the route and the travel plan, or may determine the operation.

Like the robot 100a, the self-driving vehicle 100b may use the sensor information acquired from at least one sensor among the lidar, the radar, and the camera so as to determine the travel route and the travel plan.

In particular, the self-driving vehicle 100b may recognize the environment or objects for an area covered by a field of view or an area over a certain distance by receiving the sensor information from external devices, or may receive directly recognized information from the external devices.

The self-driving vehicle 100b may perform the above-described operations by using the learning model composed of at least one artificial neural network. For example, the self-driving vehicle 100b may recognize the surrounding environment and the objects by using the learning model, and may determine the traveling movement line by using the recognized surrounding information or object information. The learning model may be learned directly from the self-driving vehicle 100a or may be learned from an external device such as the AI server 200.

At this time, the self-driving vehicle 100b may perform the operation by generating the result by directly using the learning model, but the sensor information may be transmitted to the external device such as the AI server 200 and the generated result may be received to perform the operation.

The self-driving vehicle 100b may use at least one of the map data, the object information detected from the sensor information, or the object information acquired from the external apparatus to determine the travel route and the travel plan, and may control the driving unit such that the self-driving vehicle 100b travels along the determined travel route and travel plan.

The map data may include object identification information about various objects arranged in the space (for example, road) in which the self-driving vehicle 100b travels. For example, the map data may include object identification information about fixed objects such as street lamps, rocks, and buildings and movable objects such as vehicles and pedestrians. The object identification information may include a name, a type, a distance, and a position.

In addition, the self-driving vehicle 100b may perform the operation or travel by controlling the driving unit based on the control/interaction of the user. At this time, the self-driving vehicle 100b may acquire the intention information of the interaction due to the user's operation or speech utterance, and may determine the response based on the acquired intention information, and may perform the operation.

### <AI + XR>

The XR device 100c, to which the AI technology is applied, may be implemented by a head-mount display (HMD), a head-up display (HUD) provided in the vehicle, a television, a mobile phone, a smartphone, a computer, a wearable device, a home appliance, a digital signage, a vehicle, a fixed robot, a mobile robot, or the like.

The XR device 100c may analyzes three-dimensional point cloud data or image data acquired from various sensors or the external devices, generate position data and attribute data for the three-dimensional points, acquire information about the surrounding space or the real object, and render to output the XR object to be output. For example, the XR device 100c may output an XR object including the additional information about the recognized object in correspondence to the recognized object.

The XR device 100c may perform the above-described operations by using the learning model composed of at least one artificial neural network. For example, the XR device 100c may recognize the real object from the three-dimensional point cloud data or the image data by using the learning model, and may provide information corresponding to the recognized real object. The learning model may be directly learned from the XR device 100c, or may be learned from the external device such as the AI server 200.

At this time, the XR device 100c may perform the operation by generating the result by directly using the learning model, but the sensor information may be transmitted to the external device such as the AI server 200 and the generated result may be received to perform the operation.

### <AI + Robot + Self-Driving>

The robot 100a, to which the AI technology and the self-driving technology are applied, may be implemented as a guide robot, a carrying robot, a cleaning robot, a wearable robot, an entertainment robot, a pet robot, an unmanned flying robot, or the like.

The robot 100a, to which the AI technology and the self-driving technology are applied, may refer to the robot itself having the self-driving function or the robot 100a interacting with the self-driving vehicle 100b.

The robot 100a having the self-driving function may collectively refer to a device that moves for itself along the given movement line without the user's control or moves for itself by determining the movement line by itself.

The robot 100a and the self-driving vehicle 100b having the self-driving function may use a common sensing method so as to determine at least one of the travel route or the travel plan. For example, the robot 100a and the self-driving vehicle 100b having the self-driving function may determine at least one of the travel route or the travel plan by using the information sensed through the lidar, the radar, and the camera.

The robot 100a that interacts with the self-driving vehicle 100b exists separately from the self-driving vehicle 100b and may perform operations interworking with the self-driving function of the self-driving vehicle 100b or interworking with the user who rides on the self-driving vehicle 100b.

At this time, the robot 100a interacting with the self-driving vehicle 100b may control or assist the self-driving function of the self-driving vehicle 100b by acquiring sensor information on behalf of the self-driving vehicle 100b and providing the sensor information to the self-driving vehicle 100b, or by acquiring sensor information, generating environment information or object information, and providing the information to the self-driving vehicle 100b.

Alternatively, the robot 100a interacting with the self-driving vehicle 100b may monitor the user boarding the self-driving vehicle 100b, or may control the function of the self-driving vehicle 100b through the interaction with the user. For example, when it is determined that the driver is in a drowsy state, the robot 100a may activate the self-driving function of the self-driving vehicle 100b or assist the control of the driving unit of the self-driving vehicle 100b. The function of the self-driving vehicle 100b controlled by the robot 100a may include not only the self-driving function but also the function provided by the navigation system or the audio system provided in the self-driving vehicle 100b.

Alternatively, the robot 100a that interacts with the self-driving vehicle 100b may provide information or assist the function to the self-driving vehicle 100b outside the self-driving vehicle 100b. For example, the robot 100a may provide traffic information including signal information and the like, such as a smart signal, to the self-driving vehicle 100b, and automatically connect an electric charger to a charging port by interacting with the self-driving vehicle 100b like an automatic electric charger of an electric vehicle.

### <AI + Robot + XR>

The robot 100a, to which the AI technology and the XR technology are applied, may be implemented as a guide robot, a carrying robot, a cleaning robot, a wearable robot, an entertainment robot, a pet robot, an unmanned flying robot, a drone, or the like.

The robot 100a, to which the XR technology is applied, may refer to a robot that is subjected to control/interaction in an XR image. In this case, the robot 100a may be separated from the XR device 100c and interwork with each other.

When the robot 100a, which is subjected to control/interaction in the XR image, may acquire the sensor information from the sensors including the camera, the robot 100a or the XR device 100c may generate the XR image based on the sensor information, and the XR device 100c may output the generated XR image. The robot 100a may operate based on the control signal input through the XR device 100c or the user's interaction.

For example, the user can confirm the XR image corresponding to the time point of the robot 100a interworking remotely through the external device such as the XR device 100c, adjust the self-driving travel path of the robot 100a through interaction, control the operation or driving, or confirm the information about the surrounding object.

### <AI + Self-Driving + XR>

The self-driving vehicle 100b, to which the AI technology and the XR technology are applied, may be implemented as a mobile robot, a vehicle, an unmanned flying vehicle, or the like.

The self-driving driving vehicle 100b, to which the XR technology is applied, may refer to a self-driving vehicle having a means for providing an XR image or a self-driving vehicle that is subjected to control/interaction in an XR image. Particularly, the self-driving vehicle 100b that is subjected to control/interaction in the XR image may be distinguished from the XR device 100c and interwork with each other.

The self-driving vehicle 100b having the means for providing the XR image may acquire the sensor information from the sensors including the camera and output the generated XR image based on the acquired sensor information. For example, the self-driving vehicle 100b may include an HUD to output an XR image, thereby providing a passenger with a real object or an XR object corresponding to an object in the screen.

At this time, when the XR object is output to the HUD, at least part of the XR object may be outputted so as to overlap the actual object to which the passenger's gaze is directed. Meanwhile, when the XR object is output to the display provided in the self-driving vehicle 100b, at least part of the XR object may be output so as to overlap the object in the screen. For example, the self-driving vehicle 100b may output XR objects corresponding to objects such as a lane, another vehicle, a traffic light, a traffic sign, a two-wheeled vehicle, a pedestrian, a building, and the like.

When the self-driving vehicle 100b, which is subjected to control/interaction in the XR image, may acquire the sensor information from the sensors including the camera, the self-driving vehicle 100b or the XR device 100c may generate the XR image based on the sensor information, and the XR device 100c may output the generated XR image. The self-driving vehicle 100b may operate based on the control signal input through the external device such as the XR device 100c or the user's interaction.

The following is a brief description of artificial intelligence.

Artificial intelligence (AI) is one field of computer engineering and information technology for studying a method of enabling a computer to perform thinking, learning, and self-development that can be performed by human intelligence and may denote that a computer imitates an intelligent action of a human.

Moreover, AI is directly/indirectly associated with the other field of computer engineering without being individually provided. Particularly, at present, in various fields of information technology, an attempt to introduce AI components and use the AI components in solving a problem of a corresponding field is being actively done.

Machine learning is one field of AI and is a research field which enables a computer to perform learning without an explicit program.

In detail, machine learning may be technology which studies and establishes a system for performing learning based on experiential data, performing prediction, and autonomously enhancing performance and algorithms relevant thereto. Algorithms of machine learning may use a method which establishes a specific model for obtaining prediction or decision on the basis of input data, rather than a method of executing program instructions which are strictly predefined.

The term "machine learning" may be referred to as "machine learning."

In machine learning, a number of machine learning algorithms for classifying data have been developed. Decision tree, Bayesian network, support vector machine (SVM), and artificial neural network (ANN) are representative examples of the machine learning algorithms.

The decision tree is an analysis method of performing classification and prediction by schematizing a decision rule into a tree structure.

The Bayesian network is a model where a probabilistic relationship (conditional independence) between a plurality of variables is expressed as a graph structure. The Bayesian network is suitable for data mining based on unsupervised learning.

The SVM is a model of supervised learning for pattern recognition and data analysis and is mainly used for classification and regression.

The ANN is a model which implements the operation principle of biological neuron and a connection relationship between neurons and is an information processing system where a plurality of neurons called nodes or processing elements are connected to one another in the form of a layer structure.

The ANN is a model used for machine learning and is a statistical learning algorithm inspired from a neural network (for example, brains in a central nervous system of animals) of biology in machine learning and cognitive science.

In detail, the ANN may denote all models where an artificial neuron (a node) of a network which is formed through a connection of synapses varies a connection strength of synapses through learning, thereby obtaining an ability to solve problems.

The term "ANN" may be referred to as "neural network."

The ANN may include a plurality of layers, and each of the plurality of layers may include a plurality of neurons. Also, the ANN may include a synapse connecting a neuron to another neuron.

The ANN may be generally defined by the following factors: (1) a connection pattern between neurons of a different layer; (2) a learning process of updating a weight of a connection; and (3) an activation function for generating an output value from a weighted sum of inputs received from a previous layer.

The ANN may include network models such as a deep neural network (DNN), a recurrent neural network (RNN), a bidirectional recurrent deep neural network (BRDNN), a multilayer perceptron (MLP), and a convolutional neural network (CNN), but is not limited thereto.

In this specification, the term "layer" may be referred to as "layer."

The ANN may be categorized into single layer neural networks and multilayer neural networks, based on the number of layers.

General single layer neural networks are configured with an input layer and an output layer.

Moreover, general multilayer neural networks are configured with an input layer, at least one hidden layer, and an output layer.

The input layer is a layer which receives external data, and the number of neurons of the input layer is the same the number of input variables, and the hidden layer is located between the input layer and the output layer and receives a signal from the input layer to extract a characteristic from the received signal and may transfer the extracted characteristic to the output layer. The output layer receives a signal from the hidden layer and outputs an output value based on the received signal. An input signal between neurons may be multiplied by each connection strength (weight), and values obtained through the multiplication may be summated. When the sum is greater than a threshold value of a neuron, the neuron may be activated and may output an output value obtained through an activation function.

The DNN including a plurality of hidden layers between an input layer and an output layer may be a representative ANN which implements deep learning which is a kind of machine learning technology.

The term "deep learning" may be referred to as "deep learning."

The ANN may be trained by using training data. Here, training may denote a process of determining a parameter of the ANN, for achieving purposes such as classifying, regressing, or clustering input data. A representative example of a parameter of the ANN may include a weight assigned to a synapse or a bias applied to a neuron.

An ANN trained based on training data may classify or cluster input data, based on a pattern of the input data.

In this specification, an ANN trained based on training data may be referred to as a trained model.

Next, a learning method of an ANN will be described.

The learning method of the ANN may be largely classified into supervised learning, unsupervised learning, semi-supervised learning, and reinforcement learning.

The supervised learning may be a method of machine learning for analogizing one function from training data.

Moreover, in analogized functions, a function of outputting continual values may be referred to as regression, and a function of predicting and outputting a class of an input vector may be referred to as classification.

In the supervised learning, an ANN may be trained in a state where a label of training data is assigned.

Here, the label may denote a right answer (or a result value) to be inferred by an ANN when training data is input to the ANN.

In this specification, a right answer (or a result value) to be inferred by an ANN when training data is input to the ANN may be referred to as a label or labeling data.

Moreover, in this specification, a process of assigning a label to training data for learning of an ANN may be referred to as a process which labels labeling data to training data.

In this case, training data and a label corresponding to the training data may configure one training set and may be inputted to an ANN in the form of training sets.

Training data may represent a plurality of features, and a label being labeled to training data may denote that the label is assigned to a feature represented by the training data. In this case, the training data may represent a feature of an input object as a vector type.

An ANN may analogize a function corresponding to an association relationship between training data and labeling data by using the training data and the labeling data. Also, a parameter of the ANN may be determined (optimized) through evaluating the analogized function.

The unsupervised learning is a kind of machine learning, and in this case, a label may not be assigned to training data.

In detail, the unsupervised learning may be a learning method of training an ANN so as to detect a pattern from training data itself and classify the training data, rather than to detect an association relationship between the training data and a label corresponding to the training data.

Examples of the unsupervised learning may include clustering and independent component analysis.

In this specification, the term "clustering" may be referred to as "clustering."

Examples of an ANN using the unsupervised learning may include a generative adversarial network (GAN) and an autoencoder (AE).

The GAN is a method of improving performance through competition between two different AIs called a generator and a discriminator.

In this case, the generator is a model for creating new data and generates new data, based on original data.

Moreover, the discriminator is a model for recognizing a pattern of data and determines whether inputted data is original data or fake data generated from the generator.

Moreover, the generator may be trained by receiving and using data which does not deceive the discriminator, and the discriminator may be trained by receiving and using deceived data generated by the generator. Therefore, the generator may evolve so as to deceive the discriminator as much as possible, and the discriminator may evolve so as to distinguish original data from data generated by the generator.

The AE is a neural network for reproducing an input as an output.

The AE may include an input layer, at least one hidden layer, and an output layer.

In this case, the number of node of the hidden layer may be smaller than the number of nodes of the input layer, and thus, a dimension of data may be reduced, whereby compression or encoding may be performed.

Moreover, data outputted from the hidden layer may enter the output layer. In this case, the number of nodes of the output layer may be larger than the number of nodes of the hidden layer, and thus, a dimension of the data may increase, and thus, decompression or decoding may be performed.

The AE may control the connection strength of a neuron through learning, and thus, input data may be expressed as hidden layer data. In the hidden layer, information may be expressed by using a smaller number of neurons than those of the input layer, and input data being reproduced as an output may denote that the hidden layer detects and expresses a hidden pattern from the input data.

The semi-supervised learning is a kind of machine learning and may denote a learning method which uses both training data with a label assigned thereto and training data with no label assigned thereto.

As a type of semi-supervised learning technique, there is a technique which infers a label of training data with no label assigned thereto and performs learning by using the inferred label, and such a technique may be usefully used for a case where the cost expended in labeling is large.

The reinforcement learning may be a theory where, when an environment where an agent is capable of determining an action to take at every moment is provided, the best way is obtained through experience without data.

The reinforcement learning may be performed by a Markov decision process (MDP).

To describe the MDP, firstly an environment where pieces of information needed for taking a next action of an agent may be provided, secondly an action which is to be taken by the agent in the environment may be defined, thirdly a reward provided based on a good action of the agent and a penalty provided based on a poor action of the agent may be defined, and fourthly an optimal policy may be derived through experience which is repeated until a future reward reaches a highest score.

Artificial neural network has its structure specified by model configuration, activation function, loss function or cost function, learning algorithm, optimization algorithm, etc., and Hyperparameters may be set in advance before learning, and model parameters may be set through learning to specify contents.

For example, elements for determining the structure of the artificial neural network may include the number of hidden layers, the number of hidden nodes included in each hidden layer, an input feature vector, a target feature vector, and the like.

The Hyperparameter includes several parameters that must be set initially for learning, such as an initial value of a model parameter. In addition, the model parameter includes various parameters to be determined through learning.

For example, the Hyperparameter may include a weight initial value between nodes, a bias initial value between nodes, a mini-batch size, a number of learning repetitions, a learning rate, and the like. Then, the model parameter may include a weight between nodes, a bias between nodes, and the like.

The loss function can be used for an index (reference) for determining optimum model parameters in a training process of an artificial neural network. In an artificial neural network, training means a process of adjusting model parameters to reduce the loss function and the object of training can be considered as determining model parameters that minimize the loss function.

The loss function may mainly use Mean Squared Error (MSE) or Cross Entropy Error (CEE), but the present invention is not limited thereto.

The CEE may be used when a correct answer label is one-hot encoded. One-hot encoding is an encoding method for setting a correct answer label value to 1 for only neurons corresponding to a correct answer and setting a correct answer label to 0 for neurons corresponding to an incorrect answer.

A learning optimization algorithm may be used to minimize a loss function in machine learning or deep learning, as the learning optimization algorithm, there are Gradient Descent (GD), Stochastic Gradient Descent (SGD), Momentum, NAG (Nesterov Accelerate Gradient), Adagrad, AdaDelta, RMSProp, Adam, and Nadam.

The GD is a technique that adjusts model parameters such that a loss function value decreases in consideration of the gradient of a loss function in the current state.

The direction of adjusting model parameters is referred to as a step direction and the size of adjustment is referred to as a step size.

At this time, the step size may mean a learning rate.

A gradient descent method may obtain a slope by partial-differentiating the loss function by each of model parameters, and update by changing the learning parameters by the learning rate in the obtained gradient direction.

The SGD is a technique that increases the frequency of gradient descent by dividing training data into mini-batches and performing the GD for each of the mini-batches.

The Adagrad, AdaDelta, and RMSProp in the SGD are techniques that increase optimization accuracy by adjusting the step size. The momentum and the NAG in the SGD are techniques that increase optimization accuracy by adjusting the step direction. The Adam is a technique that increases optimization accuracy by adjusting the step size and the step direction by combining the momentum and the RMSProp. The Nadam is a technique that increases optimization accuracy by adjusting the step size and the step direction by combining the NAG and the RMSProp.

The learning speed and accuracy of an artificial neural network greatly depends on not only the structure of the artificial neural network and the kind of a learning optimization algorithm, but the hyperparameters. Accordingly, in order to acquire a good trained model, it is important not only to determine a suitable structure of an artificial neural network, but also to set suitable hyperparameters.

In general, hyperparameters are experimentally set to various values to train an artificial neural network, and are set to optimum values that provide stable learning speed and accuracy using training results.

Meanwhile, the term "AI apparatus 100" may be used interchangeably with the term "AI server 100."

The input unit may include a communication unit, and the input data may be inputted to the AI server through the input unit.

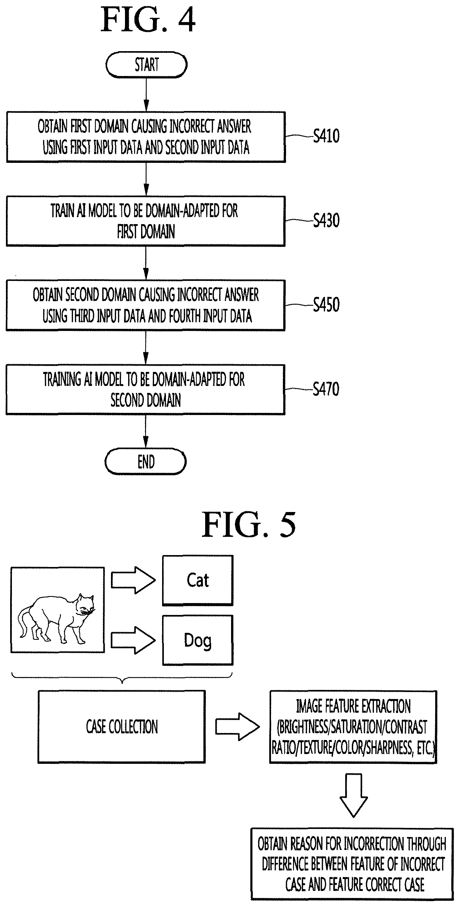

Fig. 4 is a view illustrating an operation method of an AI server according to an embodiment of the present invention.

An AI server according to an embodiment of the present invention may include, when a first output value outputted by an AI model with respect to first input data is correct and a second output value outputted by the AI model with respect to second input data is incorrect, using the first input data and the second input data to obtain a first domain causing an incorrect answer (S410), training the AI model to be domain-adapted for the first domain (S430), when a third output value outputted by the trained AI model with respect to third input data is correct and a fourth output value outputted by the trained AI model with respect to fourth input data is incorrect, using the third input data and the fourth input data to obtain a second domain causing an incorrect answer (S450), and retraining the trained AI model to be domain-adapted for the second domain (S470).

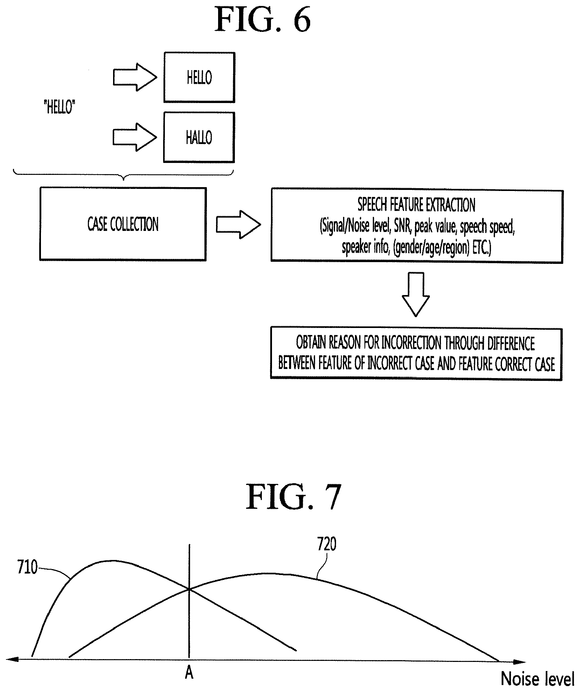

Figs. 5 and 7 are views for describing a method of acquiring a domain causing an incorrect answer according to an embodiment of the present invention.

Fig. 5 is a view for describing a domain in an image recognition model, according to an embodiment of the present invention.

The AI model according to the embodiment of the present invention may be an image recognition model. In addition, the image recognition model may be a neural network trained to classify images.

Specifically, the learning device 200 may generate an image recognition model by training a neural network using training image data and labeling data corresponding to the training image data. Here, the labeling data may be a name of an image.

Meanwhile, the image recognition model may be mounted on the terminal.

In addition, when image data is inputted, the image recognition model may output a result value corresponding to the input image data.

In detail, when image data is inputted, the image recognition model may extract one or more features from the image data. In addition, the image recognition model may output a result value of classifying the received image data into any one of a plurality of classes using one or more features.

Here, the feature extracted by the image recognition model may represent brightness, saturation, contrast ratio, texture, color, sharpness, etc. of the input data.

Meanwhile, the domain may mean a component of the image data that affects the classification of the image data by the image recognition model.

For example, domains may include brightness, saturation, contrast ratio, texture, color, sharpness, and the like.

Then, the first component (e.g., brightness) that affects the classification of the image data by the image recognition model may be the first domain, and the second component (e.g., color) that affects the classification of the image data by the image recognition model may be the second domain.

On the other hand, when the image data is received, the image recognition model may extract features representing a plurality of domains, classify the image data using the extracted features, and output a result value. In this case, the result value may be correct or incorrect.

For example, as shown in Fig. 5, when image data of a cat is inputted, the image recognition model may output a first output value (cat) that is a correct answer, and a second output value (dog) that is an incorrect answer.

Then, the reason that the incorrect answer is outputted may be that a feature of the training input data used to generate the image recognition model in a laboratory environment and a feature of the input data provided to the image recognition model in an actual use environment may be different.

For example, the training input data used to generate the image recognition model may be image data collected in a high brightness environment. For example, the training input data used to generate the image recognition model may be image data collected in a high brightness environment.

In addition, since training on the image data collected in a low brightness environment is insufficient, the image recognition model may output an incorrect answer, thereby causing a problem in that the performance of the image recognition model is lowered.

Fig. 6 is a view for describing a domain in a speech recognition model, according to an embodiment of the present invention.

The AI model according to the embodiment of the present invention may be a speech recognition model. In addition, the speech recognition model may be a neural network trained to classify speeches.

Specifically, the learning device 200 may generate a speech recognition model by training a neural network using training speech data and labeling data corresponding to the training speech data. Here, the labeling data may be a linguistic meaning of a character string or speech data corresponding to the speech data.

Meanwhile, the speech recognition model may be mounted on the terminal.

In addition, when speech data is inputted, the speech recognition model may output a result value corresponding to the input speech data.

In detail, when speech data is inputted, the speech recognition model may extract one or more features from the speech data. In addition, the speech recognition model may output a result value of classifying the received speech data into any one of a plurality of classes using one or more features.

Here, features extracted by the speech recognition model include the signal level of the input data, the noise level, the signal-to-noise ratio (SNR), the peak value, and the speech speed, or speaker information (at least one of gender, age, or region).

Meanwhile, the domain may mean a component of the speech data that affects the classification of the speech data by the speech recognition model.

For example, the domain may include signal level, noise level, SNR, peak value, speech speed, gender, age, or region.

Then, the first component (e.g., gender) that affects the classification of the speech data by the speech recognition model may be the first domain, and the second component (e.g., noise level) that affects the classification of the speech data by the speech recognition model may be the second domain.

On the other hand, when the speech data is received, the speech recognition model may extract features representing a plurality of domains, classify the speech data using the extracted features, and output a result value. In this case, the result value may be correct or incorrect.

For example, as shown in Fig. 6, when the speech data "hello" is inputted, the speech recognition model may output a first output value (hello) that is a correct answer or a second output value (hallo) that is an incorrect answer.

Then, the reason that the incorrect answer is outputted may be that a feature of the training input data used to generate the speech recognition model in a laboratory environment and a feature of the input data provided to the speech recognition model in an actual use environment may be different.

For example, the training input data used to generate the speech recognition model may be speech data collected in a low noise environment. For example, the input data provided to the speech recognition model in the actual use environment may be speech data collected in a noisy environment.

In addition, since training on the speech data collected in a noisy environment is insufficient, the speech recognition model may output an incorrect answer, thereby causing a problem in that the performance of the speech recognition model is lowered.

On the other hand, the correct case and the incorrect case can be collected, and the AI model can be trained based on the difference in the characteristics of the correct case and the incorrect case.

This will be described with reference to Fig. 7.

Fig. 7 is a view for describing a method of determining a domain that is a target of domain adaptation according to an embodiment of the present invention.

The processor of the AI server can collect input data inputted into the AI model. The input data may not mean one input data but may collectively mean various input data provided to one or more AI models.

In this case, the processor of the AI server can receive input data from a plurality of terminals equipped with an AI model through a communication unit.

In addition, the processor of the AI server may collect input data from which the AI model outputs a correct answer and input data from which the AI model outputs an incorrect answer.

Specifically, if the first output value outputted by the AI model with respect to the first input data is correct and the second output value outputted by the AI model with respect to the second input data is incorrect, the processor of the AI server may collect the first input data and the second input data.

Here, the first input data may also not mean one input data but mean a variety of input data provided to one or a plurality of AI models to output correct answers.

In addition, the second input data may also not mean one input data but mean a variety of input data provided to one or a plurality of AI models to output incorrect answers.

In addition, the processor of the AI server may acquire the first domain causing the incorrect answer using the first input data and the second input data.

In detail, when the AI model outputs an output value using features corresponding to a plurality of domains, the processor of the AI server may acquire the first domain causing the incorrect answer using the distribution of the correct case and the distribution of the incorrect case for each of the plurality of domains.

More specifically, the processor of the AI server may perform a distribution similarity measure of the first input data and the second input data for each domain.

For example, the processor of the AI server may measure distribution similarity between the first input data (data causing the correct answer) and the second input data (data causing the incorrect answer), for the first domain (e.g., noise level).

For another example, the processor of the AI server may measure distribution similarity between the first input data (data causing the correct answer) and the second input data (data causing the incorrect answer), for the second domain (e.g., gender).

That is, the processor of the AI server may calculate a distance between the distribution 710 of the first input data (data causing the correct answer) and the distribution 720 of the second input data (data causing the incorrect answer), for each domain.

The distribution similarity measure may be performed by KL-Divergence, Jensen-Shannon (JS) divergence, earth mover distance (EMD), Bhattacharyya Distance, and the like.

In addition, distribution similarity measure may be performed by a Domain Adversarial Training method such as Domain adversarial training of neural networks (DANN), and the like, a distribution measurement method such as a kernel method for the two sample problem (MMD), Correlation Alignment for Deep Domain Adaptation (Deep CORAL), and the like, and a DB taxonomy analysis method.

Here, if there are three domains of A, B, and C, the DB taxonomy analysis method may be a way to measure the performance in another domain with the AI model trained in each domain. In this case, the AI model may exhibit high performance for domains with similar distributions, and the AI model may exhibit low performance for domains with similar distributions.

Meanwhile, the processor of the AI server may acquire the first domain causing the incorrect answer among the plurality of domains.

Specifically, the processor of the AI server may acquire the first domain in which the distance between the distribution 710 of the first input data (data causing the correct answer) and the distribution 720 of the second input data (data causing the incorrect answer) is greater than the preset value among the plurality of domains. Here, the distribution may mean a distribution of features in each domain.

In addition, when the AI model outputs an output value by using features corresponding to a plurality of domains, the processor of the AI server may acquire the first domain causing the most incorrect answer among the plurality of domains.

In detail, the processor of the AI server may acquire the first domain causing the most incorrect answer among the plurality of domains by using the distribution of the first input data (data causing the correct answer) and the second input data (data causing the incorrect answer) for each of the plurality of domains. Here, the distribution may mean a distribution of features in each domain.

More specifically, the processor of the AI server may acquire a first domain having a largest distance between a distribution of the first input data (data causing a correct answer) and the second input data (data causing an incorrect answer) among a plurality of domains.

For example, it is assumed that the distance between the distribution of the first input data (data causing the correct answer) and the second input data (data causing the incorrect answer) is largest in the first domain (e.g., gender) among the plurality of domains, the distance between the distribution of the first input data (data causing the correct answer) and the distribution of the second input data (data causing the incorrect answer) is intermediate in the second domain (e.g., the magnitude of the noise) among the plurality of domains, and the distance between the distribution of the first input data (data causing the correct answer) and the second input data (data causing the incorrect answer) is smallest in the third domain (e.g., SNR) among the plurality of domains.

And, the fact that the distance between the distribution of the first input data (data causing the correct answer) and the distribution of the second input data (data causing the incorrect answer) is the largest in the first domain (e.g., gender) may mean that the first domain has the greatest influence on the AI model outputting an incorrect answer.

Accordingly, the processor of the AI server may acquire a first domain (gender) having a largest distance between a distribution of the first input data (data causing a correct answer) and the second input data (data causing an incorrect answer) among a plurality of domains.

In other words, the processor of the AI server may acquire the first domain (gender) having the smallest distribution similarity between the distribution of the first input data (data causing the correct answer) and the distribution of the second input data (data causing the incorrect answer) among a plurality of domains.

Here, the first domain having the largest distance between the distribution of the first input data (data causing the correct answer) and the distribution of the second input data (data causing the incorrect answer) is a domain in which a feature that distinguishes a correct answer from an incorrect answer is the most frequent.

For example, if the first input data (data causing the correct answer) is an images taken at bright brightness, the second input data (data causing the incorrect answer) is an image taken in dark brightness, and brightness is the factor that most influences the distinction between correct and incorrect answers, the domain "brightness" may be a domain in which a feature that distinguishes a correct answer from an incorrect answer is most frequent.

Accordingly, the first domain having the largest distance between the distribution of the first input data (data causing the correct answer) and the distribution of the second input data (data causing the incorrect answer) may be a domain that most causes an incorrect answer among the plurality of domains. That is, the first domain may be a domain having the greatest influence on the performance degradation of the AI model among the plurality of domains.

Meanwhile, a domain distinguishing a correct answer from an incorrect answer, that is, a domain causing an incorrect answer, may be determined through a feature selection technique using various clusters. Here, as a feature selection technique, a recursive feature elimination (RFE) or an accumulated local effect (ALE) may be used.

Meanwhile, the processor may divide the first domain into two sub-domains, and here, the sub-domain may include a 1-1 domain and a 1-2 domain.

Here, the 1-1 domain may be a domain in which features classified as correct answers are frequent in the first domain. In addition, the 1-2 domain may be a domain in which features classified as incorrect answers are frequent in the second domain.

In other words, the 1-1 domain may be a domain that greatly causes a correct answer in the first domain. In addition, the 1-2 domain may be a domain that greatly causes an incorrect answer in the second domain.

For example, if brightness is the most important factor in distinguishing correct and incorrect answers, the first input data (data causing the correct answer) is an image taken at bright brightness, and the second input data (data causing the incorrect answer) is an image taken in dark brightness, the 1-1 domain may be bright brightness and the 1-2 domain may be dark brightness.

Then, the processor of a smart door may classify the training data into the 1-1 domain and the 1-2 domain based on the reference value A.

For example, the processor of the smart door may classify the input data having a noise level smaller than the reference value A into the 1-1 domain, and may classify the input data having a noise level larger than the reference value A into the 1-2 domain.

Then, the processor may train the AI model to be domain-adapted for the first domain.

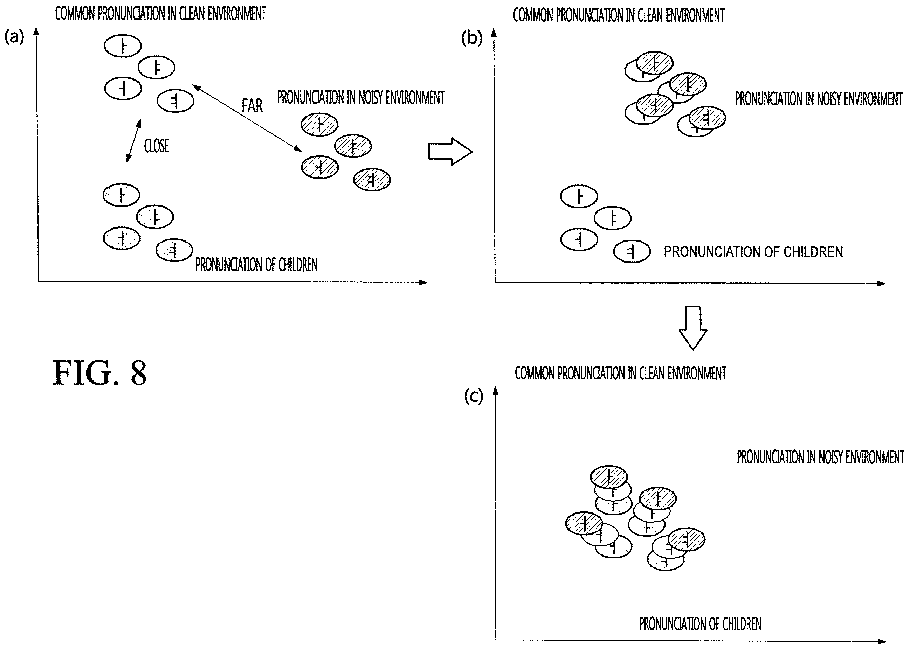

This will be described with reference to Fig. 8.

Fig. 8 is a view illustrating a domain adaptation method.

Domain adaptation (DA) is a technique that uses the knowledge already acquired to improve the probability of correct answers for new input data.

That is, domain adaptation (DA) performs mapping between a source and a target in order to allow an AI model that performs training on a source domain to operate effectively in the target domain (source domain).

And, as mapping between a source and a target is performed, the distribution of the source domain and the distribution of the target domain may be similar.

Meanwhile, in the present invention, the source domain may be a 1-1 domain corresponding to a correct answer. Also, in the present invention, the target domain (source domain) may be a 1-2 domain corresponding to an incorrect answer.

Meanwhile, in order for the AI model to be domain adaptation with respect to the first domain, the processor may train the AI model using input data corresponding to the 1-1 domain and input data corresponding to the 1-2 domain.

Specifically, the processor may train the AI model to allow the feature extracted by the AI model with respect to the input data corresponding to the 1-1 domain and the feature extracted by the AI model with respect to the input data corresponding to the 1-2 domain to be mapped to the same region.

For example, the first domain may be noise, the 1-1 domain may be small noise, and the 1-2 domain may be large noise.

Then, if the first domain (noise) is the domain that causes the most incorrect answer, the distance between the mapping region of the feature vector of the input data corresponding to the 1-1 domain and the mapping region of the feature vector of the input data corresponding to the 1-2 domain may be the largest.

In this case, the processor may train the AI model to allow the feature vector extracted by the AI model with respect to the input data corresponding to the 1-1 domain and the feature vector extracted by the AI model with respect to the input data corresponding to the 1-2 domain to be mapped to the same region.

The following describes domain adaptation using Domain adversarial training of neural networks (DANN).

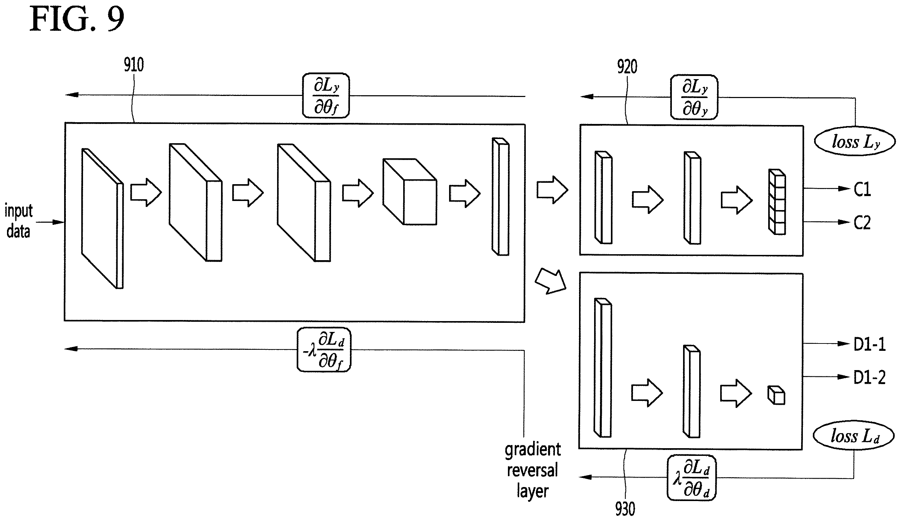

Fig. 9 is a view for describing domain adaptation using Domain Adversarial Training of Neural Networks (DANN) according to an embodiment of the present invention.

Referring to Fig. 9, the AI model 900 may include a feature extractor 910 for extracting a feature using input data, a class classifier 920 for classifying classes using the extracted features, and a domain classifier 930 for classifying domains using the extracted features.

Here, the AI model 900 mounted in the terminal may include the feature extractor 910 and the class classifier 920. In addition, in the process of performing domain adaptation in the AI server, the domain classifier 930 may be added to the AI model 900.

Meanwhile, the AI server labels the information on the class and the information on the domain to the input data corresponding to the 1-1 domain and the input data corresponding to the 1-2 domain so as to train the AI model.

In detail, the AI server may train the feature extractor 910 by using the input data corresponding to the 1-1 domain and the input data corresponding to the 1-2 domain as input values inputted to the feature extractor 910, using the information on the class as the first output value outputted from the class classifier 920, and using the information on the domain as a second output value outputted from the domain classifier 930.

Here, the information on the class may mean a correct answer (or a result value to be classified) that the class classifier 920 needs to infer using a feature extracted by the feature extractor 910. In addition, the class may mean a correct answer that the AI model mounted on the terminal should infer. For example, if the AI model is an image recognition model, two classes may be dogs and cats.

Meanwhile, the information on the domain may mean a correct answer that the domain classifier 930 should infer using a feature extracted by the feature extractor 910.

Also, the domain can be a sub-domain. For example, if the first domain is noise, the correct answer that the domain classifier 930 should infer may be a 1-1 domain (whether the input data is low noise data) or a 1-2 domain (whether the input data is high noise data).

In addition, the 1-1 domain may be a domain corresponding to a correct answer, and the 1-2 domain may be a domain corresponding to an incorrect answer. Therefore, the correct answer to be inferred by the domain classifier 930 may be input data to be determined as the correct answer by the AI model before domain adaptation, or input data to be determined as an incorrect answer by the AI model before domain adaptation.

Meanwhile, the processor may train the AI model such that the class classifier 920 classifies the class and the domain classifier does not classify the 1-1 domain and the 1-2 domain.

First, when a description is made in relation to the class classifier 920, the processor may adjust the parameter of the feature extractor 910 in the direction of minimizing the loss function value in the class classifier 920.

For example, when using a gradient descent method, the processor may obtain a slope by partial-differentiating the loss function in the class classifier 920 by each of model parameters, and update by changing the learning parameters by the learning rate in the obtained gradient direction.

On the other hand, when a description is made in relation to the domain classifier 930, the processor may train in a gradient reverse backprop in order not to distinguish whether the input data is data corresponding to the 1-1 domain or data corresponding to the 1-2 domain,

In detail, the domain classifier 930 classifies domains using the features extracted by the feature extractor 910. Then, the domain classifier 930 may adjust model parameters of the feature extractor 910 in order not to distinguish domains using the features extracted by the feature extractor 910.

For this, when the domain classifier 930 distinguishes domains well (that is, the domain classifier 930 distinguishes whether the input data corresponds to the 1-1 domain or the 1-2 domain), the processor may adjust the parameters of the feature extractor 910 in a manner that reverses the gradient. That is, when the domain classifier 930 distinguishes domains well, the processor may assign a penalty to the feature extractor 910.

In addition, the AI model should be trained to improve the performance of the classifier and to reduce the performance of the domain classifier. Therefore, a process of adjusting the model parameters of the feature extractor 910 to improve the performance of the class classifier 920 and a process of adjusting the model parameters of the feature extractor 910 to reduce the performance of the domain classifier 930 may be performed simultaneously on the same input data.

When training is repeated in this manner, features having high dependency on the first domain among features extracted by the feature extractor 910 may be gradually reduced.

Specifically, the features extracted by the feature extractor 910 before training had the highest dependency on the first domain (e.g., brightness) and based on these features, the performance of the class classifier that classifies classes is low.

However, by repeating the training, features having a high dependency on the first domain (brightness) gradually may decrease, and features that are highly dependent on new domains (for example, contrast, sharpness, shape, etc., insensitive to brightness) that can classify classes may increase.

And, since the class classifiers classify classes using features that are highly dependent on new domains that can classify classes, the classification performance of the class classifier can be improved.

In other words, the AI model has most often used the features corresponding to the first domain. As an extreme example, if the first domain is brightness, since the AI model classifies the input data corresponding to the 1-1 domain (high brightness) as dog, and the input data corresponding to the 1-2 domain (low brightness) as cat, there are many incorrect answers.

However, after the domain adaptation, the feature vector is outputted so that it is not possible to distinguish whether the input data corresponds to the 1-1 domain (high brightness) or the 1-2 domain (low brightness). Therefore, since the dependency on the first domain that causes the most incorrect answer is lowered, the performance of the AI model is improved.

On the other hand, the above-described process may be repeated in the state of changing the domain. This will be described again with reference to Fig. 8.

The trained AI model (the AI model trained to be domain-adaptive to the first domain) may operate on an AI server or may be distributed and operate on a terminal.

Then, the process of the AI server can collect input data inputted to the trained AI model.

Specifically, the processor of the AI server may collect input data from which the trained AI model outputs a correct answer and input data from which the AI model outputs an incorrect answer.

More specifically, when the third output value outputted by the trained AI model with respect to the third input data is a correct answer and the fourth output value outputted by the trained AI model with respect to the fourth input data is an incorrect answer, the processor of the AI server may collect third input data and fourth input data.

Then, the processor of the AI server may acquire the second domain causing the incorrect answer using the third input data and the fourth input data.

Specifically, when the trained AI model outputs an output value using features corresponding to a plurality of domains, the processor of the AI server may obtain the second domain that causes the incorrect answer by using the distribution of correct answer cases and the distribution of incorrect answer cases for each of multiple domains.

More specifically, the processor of the AI server may perform a distribution similarity measure of the third input data and the fourth input data for each domain.

That is, the processor of the AI server may calculate a distance between the distribution of the third input data (data causing the correct answer) and the distribution of the fourth input data (data causing the incorrect answer), for each domain.

Meanwhile, the processor of the AI server may acquire the second domain causing the incorrect answer among the plurality of domains.

Specifically, the processor of the AI server may acquire the second domain in which the distance between the distribution of the third input data (data causing the correct answer) and the distribution of the fourth input data (data causing the incorrect answer) among the plurality of domains is larger than the preset value.

In addition, when the trained AI model outputs an output value by using features corresponding to a plurality of domains, the processor of the AI server may acquire the second domain causing the most incorrect answer among the plurality of domains.

In detail, the processor of the AI server may acquire the second domain causing the most incorrect answer among the plurality of domains by using the distribution of the third input data (data causing the correct answer) and the fourth input data (data causing the incorrect answer) for each of the plurality of domains.

More specifically, the processor of the AI server may acquire a second domain having a largest distance between a distribution of the third input data (data causing a correct answer) and the fourth input data (data causing an incorrect answer) among a plurality of domains.

Here, the second domain having the largest distance between the distribution of the third input data (data causing the correct answer) and the distribution of the fourth input data (data causing the incorrect answer) is a domain in which a feature that distinguishes a correct answer from an incorrect answer is the most frequent.

Accordingly, the second domain having the largest distance between the distribution of the third input data (data causing the correct answer) and the distribution of the fourth input data (data causing the incorrect answer) may be a domain that most causes an incorrect answer among the plurality of domains. That is, the second domain may be a domain having the greatest influence on the performance degradation of the trained AI model among the plurality of domains.

Meanwhile, the second domain may be different from the first domain.

Specifically, it is assumed and described that the first domain is noise.

Referring to Fig. 8A, when the AI model outputs an incorrect answer, the domain causing the most incorrect answer is the first domain (noise). Therefore, the processor is in a state of training the AI model to be domain-adapted for the first domain.

And, referring to Fig. 8b, as the AI model is trained to be domain-adapted for the first domain, it can be seen that the feature vector extracted from the input data corresponding to the 1-1 domain (the low noise domain) and the feature vector extracted from the input data corresponding to the 1-2 domain (the high noise domain) are mapped to similar regions.

Accordingly, if the trained AI model outputs an incorrect answer, the domain causing the most incorrect answer may be changed to a second domain (age) different from the first domain (noise).

Meanwhile, the processor may divide the second domain into two sub-domains, and here, the sub-domain may include a 2-1 domain and a 2-2 domain.

Here, the 2-1 domain may be a domain in which features classified as correct answers are frequent in the second domain. In addition, the 2-2 domain may be a domain in which features classified as incorrect answers are frequent in the second domain.

In other words, the 2-1 domain may be a domain that greatly causes a correct answer in the second domain. In addition, the 2-2 domain may be a domain that greatly causes an incorrect answer in the second domain.

For example, if age is the most important factor in distinguishing correct and incorrect answers, the first input data (data causing the correct answer) is speech data of an adult, and the second input data (data causing the incorrect answer) is speech data of a child, the 2-1 domain may be adults and the 2-2 domain may be children.

Then, the processor may re-train the AI model trained to be domain-adapted for the second domain.

Specifically, in order for the trained AI model to be domain-adapted for the second domain, the processor may re-train the trained AI model using input data corresponding to the 2-1 domain and input data corresponding to the 2-2 domain.

Specifically, the processor may re-train the trained AI model to allow the feature extracted by the AI model with respect to the input data corresponding to the 2-1 domain and the feature extracted by the AI model with respect to the input data corresponding to the 2-2 domain to be mapped to the same region.

In addition, the processor labels the information on the class and the information on the domain to the input data corresponding to the 2-1 domain and the input data corresponding to the 2-2 domain so as to re-train the trained AI model.

In detail, the AI server may train the feature extractor 910 by using the input data corresponding to the 2-1 domain and the input data corresponding to the 2-2 domain as input values inputted to the feature extractor 910, using the information on the class as the first output value outputted from the class classifier 920, and using the information on the domain as a second output value outputted from the domain classifier 930.

Then, the processor may re-train the trained AI model such that the class classifier 920 classifies the class and the domain classifier does not classify the 2-1 domain and the 2-2 domain.

Fig. 8B illustrates a state in which an AI model is trained to be domain-adapted for a first domain (noise size).

And, referring to Fig. 8b, as the AI model trained to be domain-adapted for the first domain is re-trained, it can be seen that the feature vector extracted from the input data corresponding to the 2-1 domain (adults) and the feature vector extracted from the input data corresponding to the 2-2 domain (children) are mapped to similar regions.

Meanwhile, the processor may repeat this process continuously.

That is, the processor may re-train the AI model trained to be domain-adapted for the first domain and to be domain-adapted for the second domain. In addition, the processor may re-train the AI model trained to be domain-adapted for the first domain and trained to be domain-adapted for the second domain in order to be domain-adapted for the third domain.

Table 1 shows the results of experimenting the performance of the AI model trained through the method proposed in the present invention.

**[Table 1]**

| Primary training | Performance | Secondary training | Performance |
|---|---|---|---|
| First domain | 70.17 | First domain | 71.69 |
| First domain | | Second domain | 72.27 |
| Second domain | 69.5 | Second domain | 70.8 |

First, when the AI model is trained to be domain-adapted for the first domain that causes the most incorrect answer, the performance of the trained AI model was 70.17, and when the AI model is trained to be domain-adapted for the second domain that causes the second incorrect answer, the performance of the trained AI model was 69.5. This may mean that the performance of the AI model is further improved by applying domain adaptation to a domain having a large difference between the distribution of the input data causing the correct answer and the distribution of the input data causing the incorrect answer. In addition, when the AI model is trained to be domain-adapted for the first domain (noise size), the performance of the trained AI model was 70.17, and when the AI model is re-trained to be domain-adapted for the first domain (noise size), the performance of the re-trained AI model was 71.69. In addition, when the AI model is trained to be domain-adapted for the second domain (gender), the performance of the trained AI model was 69.5, and when the AI model is re-trained to be domain-adapted for the second domain (gender), the performance of the re-trained AI model was 70.08. This means that even if the domain adaptation is repeatedly performed for the same domain, the performance may continue to increase.

In addition, when the AI model is trained to be domain-adapted for the first domain (noise size) and the AI model is re-trained to be domain-adapted for the first domain (noise size), the performance of the re-trained AI model was 71.69. On the contrary, when the AI model is trained to be domain-adapted for the first domain (noise size) and the AI model is re-trained to be domain-adapted for the second domain (gender), the performance of the re-trained AI model was 72.27. This means that the performance is further improved when domain adaptation is performed while changing the domain.

In such a way, the present invention has the advantage of constantly improving the performance of the AI model by repeatedly performing domain adaptation.

In addition, since the present invention determines the domain causing the most wrong answer and first performs domain adaptation on the domain causing the most wrong answer, there is an advantage to improve the performance of the AI model faster.

In addition, according to the present invention, since domain adaptation is repeatedly performed while changing a domain that is to be a target of domain adaptation, various domains are domain-adapted. Therefore, there is an advantage of improving the performance of the AI model more quickly.

In addition, according to the present invention, each time the domain adaptation is repeatedly performed, the domain adaptation is performed by selecting a domain causing the most wrong answer. Therefore, there is an advantage of improving the performance of the AI model more quickly.

On the other hand, every time performing domain adaptation repeatedly, instead of performing domain adaptation by selecting the domain that causes the most incorrect answers, domain adaptations may be performed sequentially in the order that causes incorrect answers.

Specifically, if the first output value outputted by the AI model for the first input data is a correct answer and the second output value outputted by the AI model for the second input data is an incorrect answer, the processor may obtain a first domain causing the most incorrect answer and a second domain causing the second incorrect answer among the plurality of domains by using the first input data and the second input data. Then, the processor may train the AI model to be domain-adapted for the first domain. Then, the processor may re-train the AI model trained to be domain-adapted for the second domain.

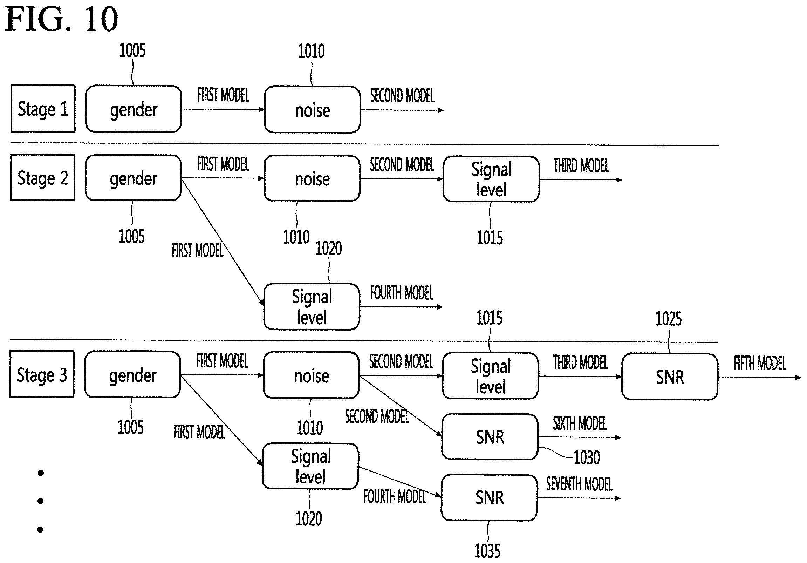

Fig. 10 is a view for describing a method of selecting an AI model having optimal performance while repeatedly performing domain adaptation and then, managing a history.

The processor can select the highest performance AI model among a plurality of AI models in which at least one of the number of domain adaptation, the target domain of domain adaptation, or the order of domain adaptation is different.

Specifically, referring to Fig. 10, the processor may perform domain adaptation in various combinations.

In detail, referring to stage 1, the processor trains an initial AI model by performing domain adaptation on a first domain (gender) (1005). The AI model trained in such a way may be referred to as a first AI model.

On the other hand, the processor may train the AI model so that the one-step previous AI model is domain-adapted for a new domain.

Specifically, referring to stage 1, the processor trains the first AI model (performing domain adaptation on the first domain (gender)) by performing domain adaptation on the second domain (size of noise) (1010). The AI model trained in such a way may be referred to as a second AI model. Then, the second AI model may be an AI model that is trained to be domain-adapted for the first domain (gender) and to be domain-adapted for the second domain (size of noise).

Here, the processor may train the AI model so that the one-step previous AI model is domain-adapted for a new domain.

In detail, referring to stage 2, the processor trains a second AI model by performing domain adaptation on a third domain (size of signal) (1015). The AI model trained in such a way may be referred to as a third AI model. Then, the third AI model may be an AI model trained to be domain-adapted for the first domain (gender), trained to be domain-adapted for the second domain (size of noise), and trained to be domain-adapted for the third domain (size of signal).

In addition, referring to stage 3, the processor trains a third AI model by performing domain adaptation on a fourth domain (SNR) (1025). The AI model trained in such a way may be referred to as a fifth AI model. Then, the fifth AI model may be an AI model trained to be domain-adapted for the first domain (gender), trained to be domain-adapted for the second domain (size of noise), trained to be domain-adapted for the third domain (size of signal), and trained to be domain-adapted for the fourth domain (SNR).

In addition, the processor may train the AI model so that the multiple-step previous AI model is domain-adapted for a new domain.

For example, referring to stage 2, the processor trains a second AI model by performing domain adaptation on a third domain (size of signal) (1020). The AI model trained in such a way may be referred to as a fourth AI model. Then, the second AI model may be an AI model that is trained to be domain-adapted for the first domain (gender) and to be domain-adapted for the third domain (size of signal). In other words, the processor may train the two-step previous AI model (first AI model) so that the two-step previous AI model (first AI model) is domain-adapted for the new domain (size of signal).

As another example, referring to stage 3, the processor trains a second AI model by performing domain adaptation on a fourth domain (SNR) (1030). The AI model trained in such a way may be referred to as a sixth AI model. Then, the sixth AI model may be an AI model trained to be domain-adapted for the first domain (gender), trained to be domain-adapted for the second domain (size of noise), and trained to be domain-adapted for the fourth domain (SNR). In other words, the processor may train the two-step previous AI model (second AI model) so that the two-step previous AI model (second AI model) is domain-adapted for the new domain (SNR).

In this manner, the processor may generates a plurality of AI models that differ in at least one of the number of domain adaptations, a target domain of domain adaptation, or the order of domain adaptation and select the highest performance AI model among the plurality of generated AI models.

Here, the determination reference of the performance may mean the accuracy of the classification (prediction) of the AI model.

Then, the processor may transmit the selected AI model to one or more terminals. In this case, the terminal may download the AI model and obtain a result value using the downloaded AI model.

On the other hand, a different order of domain adaptation may mean that the order of domain adaptation is performed on a plurality of domains. For example, the second AI model may be an AI model that is trained to be domain-adapted for the first domain and to be domain-adapted for the second domain. As another example, the third AI model may be an AI model that is trained to be domain-adapted for the second domain and then, to be domain-adapted for the first domain.

In such a way, according to the present invention, the performance of the AI model can be improved by performing domain adaptation in various combinations and selecting the AI model having the highest performance.

For example, since a method of generating a first AI model by training the initial AI model to be domain-adapted for the first domain that causes the most incorrect answer in the initial AI model, generating a second AI model by training the first AI model to be domain-adapted for the second domain that causes the most incorrect answer in the first AI model, and generating a third AI model by training the second AI model to be domain-adapted for the third domain that causes the most incorrect answer in the second AI model is focused on the fact that repeated domain adaptation to the domain that causes the most incorrect answer is likely to yield the best performance, there is also the possibility that other combinations perform better.

Therefore, the present invention has the advantage of improving the performance of the AI model by performing domain adaptation in various combinations and selecting the highest performance AI model.

For example, referring to stage 2 again, the processor may generate a second AI model by training a first AI model to be domain-adapted for the first domain (1010), and generate a third AI model by training the second AI model to be domain-adapted for the second domain (1015). In addition, the processor may generate a fourth AI model by training the first AI model to be domain-adapted for the second domain (1020). In this case, although the number of domain adaptations of the third AI model is larger, the performance of the fourth AI model may be higher than that of the third AI model. In this case, the processor may select a fourth AI model, which is a higher performance AI model, from among the third and fourth AI models.

For another example, the processor may generate a second AI model by training the AI model to be domain-adapted for the first domain (1010), and generate a third AI model by training the second AI model to be domain-adapted for the second domain (1015). In addition, the processor may select a higher-performance AI model among the second AI model and the third AI model.

On the other hand, as the number of combinations increases, the possibility that an AI model with optimal performance will be selected is increased but due to the limitations of the amount of computation and the storage space, it is impossible to hold all the combinations.

Accordingly, the processor may delete some AI models from the plurality of AI models previously generated and stored in the memory, or stop further training on the AI models.

Specifically, the processor may generate a second AI model by training the AI model to be domain-adapted for the first domain, and generate a third AI model by training the second AI model to be domain-adapted for the second domain. In addition, the processor may store the second AI model and the third AI model in a memory.

Then, when the performance of the second AI model is higher among the second AI model and the third AI model, the processor may select the second AI model and delete the third AI model from the memory.

That is, since the third AI model is a model whose performance is lower than that of the previous AI model, the third AI model may be deleted from the memory. And, as the third AI model is deleted from the memory, additional training (domain adaptation) for the third AI model may not be performed.

As another embodiment, the processor may generate a second AI model by training the AI model to be domain-adapted for the first domain, and generate a third AI model by training the second AI model to be domain-adapted for the second domain.

Then, when the performance of the third AI model increases by less than or equal to a predetermined value as compared to the performance of the second AI model, the processor may not additionally train the third AI model. That is, when the performance improvement of the third AI model is low, a branch having the third AI model as a starting point may also show low performance. Therefore, the processor may not generate a branch having the third AI model as a starting point by not additionally training the third AI model.

In this case, the processor may select another branch and continue training for domain adaptation.

For example, the processor may generate a second AI model by training the AI model to be domain-adapted for the first domain, and generate a fourth AI model by training the second AI model to be domain-adapted for the third domain.

Then, when the performance of the fourth AI model increases by less than or equal to a predetermined value as compared to the performance of the second AI model, the processor may select the fourth AI model. In addition, the processor may additionally train the fourth AI model for domain adaptation.

In another embodiment, the processor may not additionally train an AI model that is not selected as the highest performance AI model for a predetermined period among the plurality of AI models.

For embodiment, the processor may generate a second AI model by training the AI model to be domain-adapted for the first domain, and generate a third AI model by training the second AI model to be domain-adapted for the third domain. Then, since the performance of the third AI model is improved by a predetermined value or more than the performance of the second AI model, the processor stores and holds the third AI model in a memory.

On the other hand, the processor can select the highest performance AI model among a plurality of AI models.

Meanwhile, the AI server has a third AI model, but the third AI model is not selected as the highest performance AI model for a predetermined period. In this case, the processor may no longer train the third AI model, thereby preventing the generation of a branch starting from the third AI model. In addition, the processor may delete the third AI model from the memory.

In such a way, according to the present invention, some AI models of the plurality of AI models are not additionally trained or some AI models are deleted from the memory, thereby reducing the amount of computation and storage space.

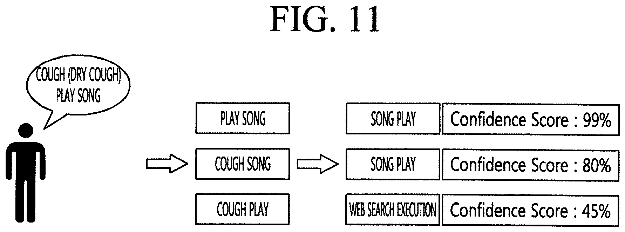

Fig. 11 is a view for describing a method of extracting an important word from a spoken text and acquiring a domain causing an incorrect answer using a feature extracted from the important word according to an embodiment of the present invention.

It is assumed and described that the spoken text of the user, that is, the input data, is composed of three words (cough, song, and play).

Here, "cough" may be a coughing sound.

The processor may extract a plurality of words included in the input data and calculate the importance of each of the extracted plurality of words.

In more detail, the processor may perform natural language processing while deleting some words (e.g., one word) among a plurality of words included in the input data.

More specifically, referring to Fig. 11A, when the input data includes the first word, the second word, and the third word, the processor may perform natural language processing on the input data including the second word and the third word except the first word.

For example, when the input data of "cough play song" is received, the processor may perform the natural language processing by providing the input data of "play song" to the natural language processing model. In this case, the natural language processing model may output a semantic analysis result and a confidence score on the input data. For example, the natural language processing model may output a semantic analysis result of song play and a confidence score of 99%.

In addition, when the input data includes the first word, the second word, and the third word, the processor may perform natural language processing on the input data including the first word and the second word except the third word.

For example, when the input data of "cough play song" is received, the processor may perform the natural language processing by providing the input data of "cough song" to the natural language processing model. In this case, the speech recognition model may output a semantic analysis result and a confidence score on the input data. For example, the natural language processing model may output a semantic analysis result of song play and a confidence score of 80%.

In addition, when the input data includes the first word, the second word, and the third word, the processor may perform natural language processing on the input data including the first word and the third word except the second word.

For example, when the input data of "cough play song" is received, the processor may perform the natural language processing by providing the input data of "cough play" to the natural language processing model. In this case, the natural language processing model may output a semantic analysis result and a confidence score on the input data. For example, the natural language processing model may output a semantic analysis result of a web search execution and a confidence score of 45%.

Meanwhile, the processor may acquire important words and unnecessary words by using semantic analysis results and confidence scores obtained by deleting a plurality of words included in the input data one by one.

Specifically, when the meaning of the spoken text and the result of the semantic analysis correspond to each other based on a result of natural language processing of specific input data excluding specific words and an output value having the highest confidence score is obtained, the processor may determine a specific word as an unnecessary word.

For example, if a semantic analysis result of song playback and a 99% confidence score are outputted based on a result of natural language processing of "play song" except "cough," the processor can determine "cough" as an unnecessary word.

In addition, when the meaning of the spoken text and the semantic analysis result do not correspond to each other based on a result of natural language processing of specific input data excluding specific words and an output value having the lowest confidence score is obtained, the processor may determine a specific word as an important word.

For example, if a semantic analysis result of a web search execution is outputted based on a result of natural language processing of "cough play" except "song", the processor can determine "song" as an important word. As another example, if a semantic analysis result of song play and a confidence score of 30% are outputted based on a result of natural language processing of "cough play" except "song," the processor can determine "song" as an important word.

Then, the processor may acquire a domain causing an incorrect answer by using a feature extracted from the important word.

Specifically, if the first output value outputted by the AI model for the first input data is a correct answer and the second output value outputted by the AI model for the second input data is an incorrect answer, the processor may extract the first feature from the important word included in the first input data and the second feature from the important word included in the second input data.

In addition, the processor may perform a distribution similarity measure of the first and second feature data.

In addition, the processor may acquire the first domain causing the most incorrect answer among the plurality of domains. In detail, the processor may obtain a first domain having a largest distance between a distribution of a first feature and a distribution of a second feature among the plurality of domains.

In other words, according to the present invention, since the features extracted from the important words are used to obtain the domain that causes the most incorrect answer, there is an advantage of further improving the recognition performance for important words.

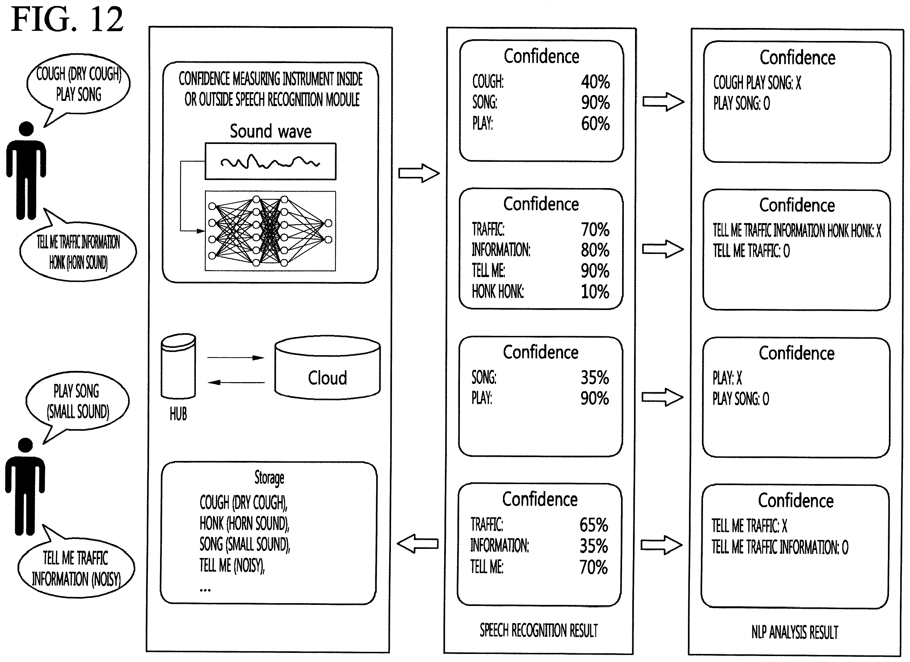

Fig. 12 is a view for describing a method of acquiring a low confidence word and distinguishing the low confidence word using the importance of the low confidence word according to an embodiment of the present invention.

Here, the confidence word may mean a word whose confidence score of the speech recognition model is a predetermined value (e.g., lower than 50%).

It is assumed and described that the spoken text of the user, that is, the input data, is composed of three words (cough, song, and play).

The processor may extract a plurality of words included in the input data and calculate a confidence score of each of the extracted plurality of words.

In detail, the processor may input the input data into the speech recognition model. In this case, the speech recognition model may output a recognition result for each of the plurality of words and a confidence score for each of the plurality of words.

For example, the speech recognition model can output a confidence score of 40% for "cough," 90% for "song," and 60% for "play." Then, the processor may determine a word having a confidence score of the speech recognition model smaller than a predetermined value as a low confidence word. For example, if the preset value is 50%, the processor may determine "cough" as a low confidence word.

For another example, for the input data "play song (small sound)", the speech recognition model can output a confidence score of 35% for "song" and 90% for "play." Then, the processor can select a low confidence word for a "song (small sound)" with a confidence score less than 50%.

Meanwhile, the processor may classify the low confidence word into an important word and an unnecessary word by using the importance of the low confidence word.

In detail, the processor may perform natural language processing by deleting a low confidence word among a plurality of words included in the input data.

For example, the processor may perform natural language processing for "play song" except for "cough" in the input data "cough play song."

For another example, the processor may perform natural language processing for "play" except for "song (small sound)" in the input data "play song (small sound)".

In this case, the natural language processing model may output a semantic analysis result and a confidence score on the input data.

On the other hand, the processor can obtain important words and unnecessary words using the semantic analysis result and confidence score outputted from the natural language processing model.

Specifically, when the meaning of the spoken text and the semantic analysis result correspond to each other and an output value with a certain confidence score or more is obtained based on a result of natural language processing of input data excluding low confidence words, the processor may determine a low confidence word as an unnecessary word.

For example, when natural language processing for "play song" except for "cough" in the input data "cough play song" is performed and the natural language processing model outputs a semantic analysis result of "play song" and a confidence score of 90%, the processor can determine "cough" as an unnecessary word.

In addition, when the meaning of the spoken text and the semantic analysis result do not correspond to each other and the output with the lowest confidence score is obtained based on a result of natural language processing of input data excluding low confidence words, the processor may determine a low confidence word as an unnecessary word.

For example, when natural language processing for "play" except for "song (small sound)" in the input data "play song (small sound)" is performed and the natural language processing model outputs a semantic analysis result of "play song" and a confidence score of 30%, the processor can determine "cough" as an important word.

Meanwhile, the processor may store unnecessary words and important words in memory.

In addition, the processor can train AI models using unnecessary words and important words as training data.

As an embodiment, as described above, the processor may acquire a domain causing an incorrect answer by using a feature extracted from the important word.

In another embodiment, the processor may train the AI model using important words having various domains and various sub-domains as training data.

For example, the processor may train the AI model by using "song" that is a speech collected in a noisy environment, "song" that is a speech collected in an intermediate noisy environment, "song" that is a speech collected in a low noise environment, "song" that is a speech spoken by a man, and "song" that is a speech spoken by a woman as an input value and by using the word "song" as an output value.

The following describes the domain adaptation method. When the first output value outputted by the AI model with respect to the first input data is a correct answer and the second output value outputted by the AI model with respect to the second input data is an incorrect answer, a domain adaptation method according to an embodiment of the present invention may include obtaining a first domain causing an incorrect answer using the first input data and the second input data, and training the AI model to be domain-adapted for the first domain.

In this case, when the third output value outputted by the trained AI model with respect to the third input data is a correct answer and the fourth output value outputted by the trained AI model with respect to the fourth input data is an incorrect answer, the method further includes obtaining a second domain that causes an incorrect answer using the third input data and the fourth input data, and re-training the trained AI model to be domain-adapted for the second domain. The second domain may be different from the first domain.

The above-described present invention can also be implemented with computer-readable codes in a computer-readable recording medium. The computer-readable recording medium is any data storage device that can store data which can thereafter be read by a computer system. Examples of the computer-readable recording medium include a Hard Disk Drive (HDD), a Solid State Disk (SSD), a Silicon Disk Drive (SDD), a ROM, a RAM, a CD-ROM, a magnetic tape, a floppy disk, and an optical data storage. Also, the computer may include the control unit 180 of the terminal. Accordingly, the detailed description is not construed as being limited in all aspects and should be considered as illustrative. The scope of the invention should be determined by reasonable interpretation of the appended claims, and all modifications within equivalent ranges of the present invention are included in the scope of the present invention.

## Claims

1. Artificial intelligence server comprising:
an input interface to which input data is inputted; and
a processor, when a first output value outputted by an artificial intelligence model with respect to first input data is correct and a second output value outputted by the artificial intelligence model with respect to second input data is incorrect, configured to use the first input data and the second input data to obtain a first domain causing an incorrect answer, and train the artificial intelligence model to be domain-adapted for the first domain.

2. The artificial intelligence server of claim 1, wherein when a third output value outputted by the trained artificial intelligence model with respect to third input data is correct and a fourth output value outputted by the trained artificial intelligence model with respect to fourth input data is incorrect, the processor obtains a second domain causing an incorrect answer using the third input data and the fourth input data; and re-trains the trained artificial intelligence model to be domain-adapted for the second domain,
wherein the second domain is different from the first domain.

3. The artificial intelligence server of claim 2, wherein when the artificial intelligence model outputs an output value using features corresponding to a plurality of domains, the processor obtains the first domain causing the most incorrect answer among the plurality of domains.

4. The artificial intelligence server of claim 3, wherein when the artificial intelligence model outputs an output value using features corresponding to the plurality of domains, the processor obtains the first domain causing the most incorrect answer among the plurality of domains by using a distribution of the first input data and a distribution of the second input data for each of the plurality of domains.

5. The artificial intelligence server of claim 3, wherein when the trained artificial intelligence model outputs an output value using features corresponding to the plurality of domains, the processor obtains the second domain causing the most incorrect answer among the plurality of domains.

6. The artificial intelligence server of claim 5, wherein when the trained artificial intelligence model outputs an output value using features corresponding to the plurality of domains, the processor obtains the second domain causing the most incorrect answer among the plurality of domains by using a distribution of the first input data and a distribution of the second input data for each of the plurality of domains.

7. The artificial intelligence server of claim 2, wherein the first domain comprises a 1-1 domain and a 1-2 domain,
wherein the processor trains the artificial intelligence model to allow a feature extracted by the artificial intelligence model with respect to input data corresponding to the 1-1 domain and a feature extracted by the artificial intelligence model with respect to input data corresponding to the 1-2 domain to be mapped to the same area.

8. The artificial intelligence server of claim 7, wherein the second domain comprises a 2-1 domain and a 2-2 domain,
wherein the processor re-trains the trained artificial intelligence model to allow a feature extracted by the trained artificial intelligence model with respect to input data corresponding to the 2-1 domain and a feature extracted by the artificial intelligence model with respect to input data corresponding to the 2-2 domain to be mapped to the same area.

9. The artificial intelligence server of claim 7, wherein the artificial intelligence model comprises:
a feature extractor configured to extract the feature using input data;
a class classifier configured to classify classes using the extracted features; and
a domain classifier configured to classify domains using the extracted features.

10. The artificial intelligence server of claim 9, wherein the processor trains the artificial intelligence model to allow the class classifier to classify the classes and prevent the domain classifier from classifying the 1-1 domain and the 1-2 domain.

11. The artificial intelligence server of claim 1, wherein the processor obtains a second domain causing a second largest incorrect answer among a plurality of domains by using the first input data and the second input data, and re-trains the trained artificial intelligence model to be domain-adapted for the second domain.

12. The artificial intelligence server of claim 1, wherein the processor selects an artificial intelligence model with the highest performance among a plurality of artificial intelligence models in which at least one of the number of domain adaptation, a target domain of domain adaptation, or the order of domain adaptation is different.

13. The artificial intelligence server of claim 12, wherein the processor
trains the artificial intelligence model to be domain-adapted for the first domain so as to generate a second artificial intelligence model,
trains the second artificial intelligence model to be domain-adapted for a second domain so as to generate a third artificial intelligence model, and
selects an artificial intelligence model with a higher performance among the second artificial intelligence model and the third artificial intelligence model.

14. The artificial intelligence server of claim 12, wherein the processor
trains the artificial intelligence model to be domain-adapted for the first domain so as to generate a second artificial intelligence model, and trains the second artificial intelligence model to be domain-adapted for the second domain so as to generate a third artificial intelligence model,
trains the artificial intelligence model to be domain-adapted for the second domain so as to generate a fourth artificial intelligence mode, and
selects an artificial intelligence model with higher performance among the third artificial intelligence model and the fourth artificial intelligence model.

15. A domain adaptation method comprising:
when a first output value outputted by an artificial intelligence model with respect to first input data is correct and a second output value outputted by the artificial intelligence model with respect to second input data is incorrect, using the first input data and the second input data to obtain a first domain causing an incorrect answer; and
training the artificial intelligence model to be domain-adapted for the first domain.
